## Europäisches Patentamt
## European Patent Office
## Office européen des brevets

(19)

(11) Veröffentlichungsnummer: **0 025 917**
**B1**

(12) **EUROPÄISCHE PATENTSCHRIFT**

(45) Veröffentlichungstag der Patentschrift:
**12.01.83**

(51) Int. Cl.³: **G 01 R 21/06**

(21) Anmeldenummer: **80105294.5**

(22) Anmeldetag: **04.09.80**

(54) **Elektronischer Drehstrom-Elektrizitätszähler für das Kondensatorumladungsverfahren.**

(30) Priorität: **21.09.79 DE 2938238**

(43) Veröffentlichungstag der Anmeldung:
**01.04.81 Patentblatt 81/13**

(45) Bekanntmachung des Hinweises auf die Patenterteilung:
**12.01.83 Patentblatt 83/2**

(84) Benannte Vertragsstaaten:
**CH DE FR GB IT LI SE**

(56) Entgegenhaltungen:
**DE-A-2 348 667**
**DE-A-2 715 321**
**DE-A-2 747 385**

(73) Patentinhaber: **SIEMENS AKTIENGESELLSCHAFT**
**Berlin und München, Postfach 22 02 61,**
**D-8000 München 22 (DE)**

(72) Erfinder: **Steinmüller, Günter, Laufamholzstrasse 65,**
**D-8500 Nürnberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Elektronischer Drehstrom-Elektrizitätszähler für das Kondensatorumladungsverfahren

Die Erfindung betrifft einen elektronischen Drehstrom-Elektrizitätszähler für das Kondensatorumladungsverfahren, bei dem jeder Phase des Drehstromnetzes ein einen Tastverhältnismodulator und einen Analogschalter aufweisenden Time-Division-Multiplizierer zugeordnet ist, zum Verarbeiten der der betreffenden Phase zugeordneten verbraucherstrom- und verbraucherspannungsproportionalen Eingangssignale, von denen das eine Eingangssignal den Tastverhältnismodulator aussteuert und das andere Eingangssignal über den vom Tastverhältnismodulator getakteten Analogschalter zum Ausgang des Time-Division-Multiplizierer geführt ist, und bei dem die Ausgangsströme der drei Time-Division-Multiplizierer einem gemeinsamen Strom-Frequenz-Wandler zugeführt sind, dessen Ausgangssignal eine kumulierende Zähleinrichtung zur Erfassung des Energieverbrauches speist.

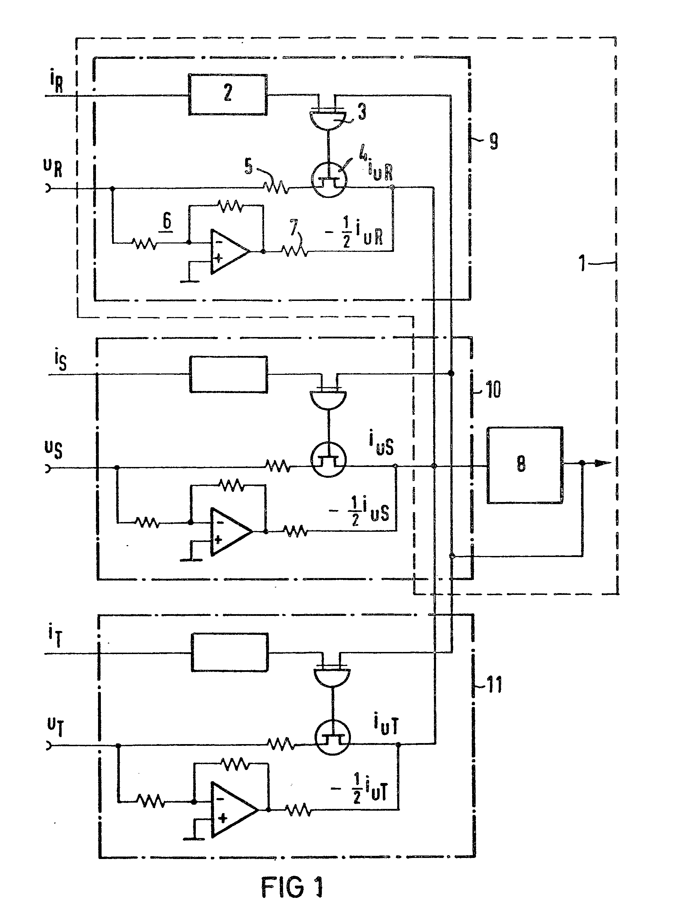

Aus der DE-A-27 47 385 ist ein elektronischer Wechselstrom-Elektrizitätszähler für das Kondensatorumladungsverfahren bekannt. Ein solcher elektronischer einphasiger Elektrizitätszähler ist in Fig. 1 mit einer gestrichelten Umrandung herausgehoben und mit dem Bezugszeichen 1 belegt. Hierbei steuert ein dem Verbraucherstrom proportionales Eingangssignal $i_R$ einen Tastverhältnismodulator 2 aus, dessen Ausgangssignal über ein Exklusiv-ODER-Gatter 3 einen Analogschalter steuert, der ein der Verbraucherspannung proportionales Eingangssignal $u_R$ nach Wandlung in einen proportionalen Strom $i_{uR}$ durch den Widerstand 5 taktet. Die aus dem Widerstand 5 und dem Analogschalter 4 bestehende Serienschaltung ist durch die Serienschaltung eines Umkehrverstärkers 6 und eines nachgeschalteten Widerstandes 7 überbrückt, wobei die Widerstände des Überbrückungszweiges so dimensioniert sind, dass im Überbrückungszweig ein Strom vin -1/2 $i_{uR}$ fliesst. Damit entsteht im Rhythmus der Taktung des Analogschalters 4 ein Strom mit den alternierenden Amplitudenwerten +1/2 $i_{uR}$, bzw. -1/2 $i_{uR}$, der einem Strom-Frequenz-Wandler 8 zugeführt ist, der einen Integrator sowie einen nachgeschalteten Komparator mit zwei Grenzwerten aufweist. Beim Erreichen des einen Grenzwertes des Komparators kehrt dieser sein Ausgangssignal um, wobei das dabei entstehende impulsförmige Signal in einer in Fig. 1 nicht dargestellten kumulierenden Zähleinrichtung zur Erfassung des Energieverbrauchers eingezählt wird. Dadurch, dass das Ausgangssignal des Strom-Frequenz-Wandlers 8 auch dem anderen Eingang des Exklusivgatters 3 zugeführt ist, wird dieser nun durch das negierte Signal des Tastverhältnismodulators 2 gespeist, so dass die Integrationsrichtung des Integrators im Strom-Frequenz-Umsetzer 8 geändert wird und das Ausgangssignal des Integrators auf den zweiten Grenzwert des Komparators zuläuft. Hier erfolgt wiederum eine Umkehr des Ausgangssignals des Komparators. Damit wird der Integrator in abwechselnder Folge aufgeladen und entladen. Die Ausgangsfrequenz des Strom-Frequenz-Wandlers 8 ist proportional zu dem Produkt des verbraucherstromproportionalen Eingangssignals $i_R$ und des verbraucherspannungsproportionalen Eingangssignals $u_R$.

Aus der DE-A-27 15 321 und der De-A-23 48 667 sind elektronische Drehstrom-Elektrizitätszähler bekannt, die nach dem Prinzip des erläuterten elektronischen Wechselstrom-Elektrizitätszählers aufgebaut sind. Ein derartiger elektronischer Drehstrom-Elektrizitätszähler ist in Fig. 1 schematisch dargestellt. Hierbei ist jeder der drei Phasen R, S und T des Drehstromnetzes eine strichpunktiert eingezeichnete Eingangsschaltung 9, 10 und 11 zugeordnet, die untereinander baugleich sind und der Eingangsschaltung 9 des aus der DE-A-27 47 385 bekannten Wechselstrom-Elektrizitätszählers 1 entsprechen. Sie weisen damit jeweils einen Tastverhältnismodulator, einen Analogschalter sowie einen den Analogschalter überbrückenden Überbrückungszweig auf. Die Ausgangssignale der Eingangsschaltungen 9, 10 und 11 sind in Punkt 12 zusammengeführt und einem gemeinsamen Strom-Frequenz-Wandler 8 zugeführt, der eine nicht dargestellte kumulierende Zähleinrichtung zur Erfassung des Energieverbrauches speist.

Der Erfindung liegt die Aufgabe zugrunde, einen elektronischen Drehstrom-Elektrizitätszähler der eingangs genannten Art so auszugestalten, dass er mit weniger Bauelementen und damit kostengünstiger und raumsparender erstellbar ist.

Die Aufgabe wird erfindungsgemäss dadurch gelöst, dass dem Strom-Frequenz-Wandler ausschliesslich die Ausgangsströme der von den jeweiligen Tastverhältnismodulatoren getakteten Analogschalter zugeführt sind. Damit entfallen sämtliche Umkehrverstärker und Widerstände in den Überbrückungszweigen zu der Serienschaltung aus Widerstand und Analogschalter. Für einen elektronischen Drehstrom-Elektrizitätszähler bedeutet dies, dass drei Operationsverstärker und neun Widerstände eingespart werden können.

Es zeigt sich nämlich, dass die Summe der Ströme in den drei Überbrückungszweigen des Drehstromzählers den Wert Null ergibt. Damit können die Überbrückungszweige ohne Beeinträchtigung der Funktion des elektronischen Drehstrom-Elektrizitätszählers entfallen.

In einer bevorzugten Ausführungsform sind die verbraucherstrom- und verbraucherspannungsproportionalen Eingangssignale direkt von den Phasenleitern abgegriffen, indem als verbraucherstromproportionales Eingangssignal der Spannungsabfall eines in jeden Phasenleiter eingefügten Messwiderstandes und als verbraucherspannungsproportionales Eingangssignal der Strom in einem an den jeweiligen Phasenleiter angeschlossenen Widerstand dient. Damit können die bisher den drei Phasen zugeordneten drei Stromwandler und drei Spannungswandler entfallen.

Weitere vorteilhafte Ausführungsformen sind Gegenstand der Unteransprüche.

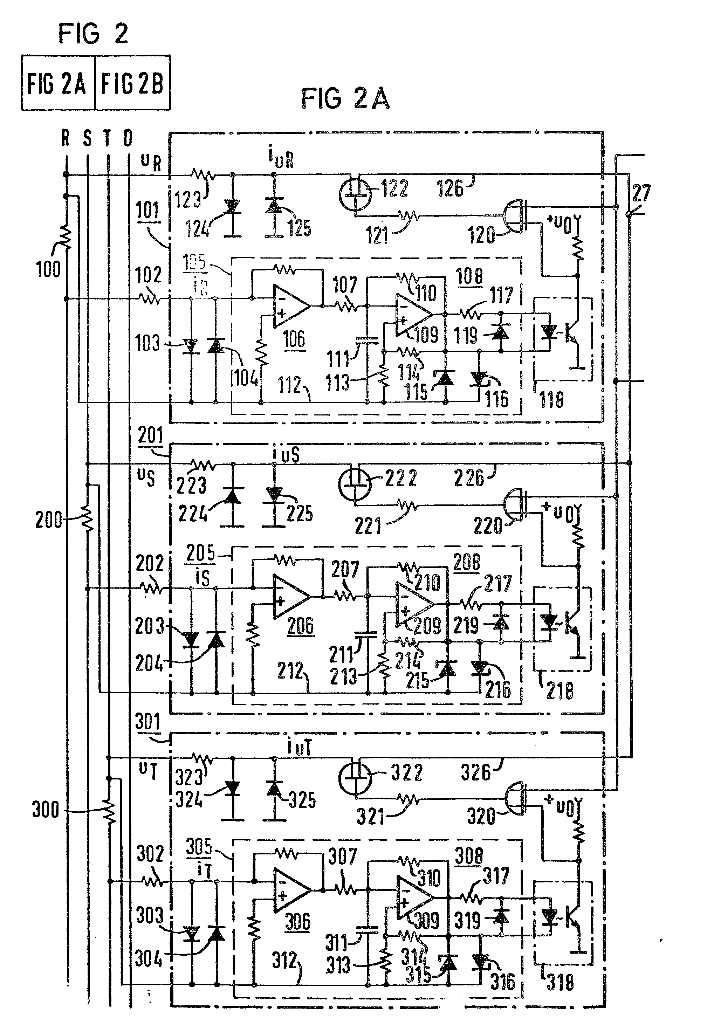

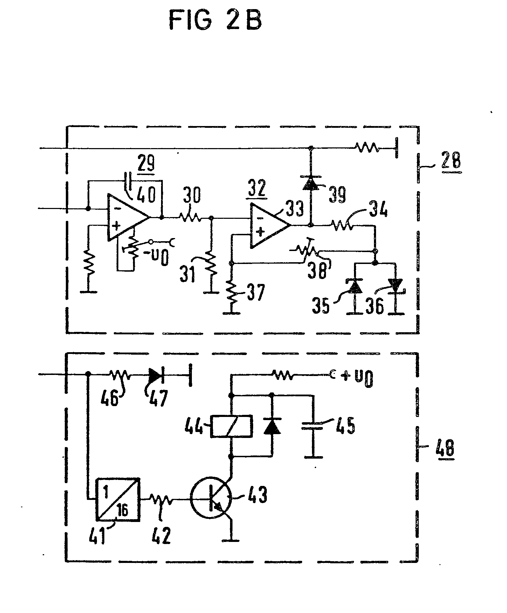

Die Erfindung wird im folgenden anhand eines in Fig. 2 dargestellten Ausführungsbeispieles näher erläutert.

Die drei Phasenleiter und der Nulleiter sind in Fig. 2 mit R, S, T und O bezeichnet. Wie aus Fig. 2 hervorgeht, sind die im wesentlichen jeweils einen Time-Division-Multiplizierer enthaltenden, den drei Phasen zugeordneten Eingangsschaltungen 101, 201 und 301 untereinander baugleich, so dass es genügt, lediglich die der Phase R zugeordnete Eingangsschaltung zu erläutern. Die als Zahlen ausgebildeten Bezugszeichen in Fig. 2 sind so aufgebaut, dass die der Phase R zugeordneten Elemente von 100 aufwärts, die der Phase S zugeordneten Elemente von 200 aufwärts und die der Phase T zugeordneten Elemente von 300 aufwärts gezählt sind.

In jedem der Phasenleiter R, S und T ist jeweils ein Messwiderstand 100, 200 und 300 mit einem niedrigen Widerstandswert eingefügt. Im Falle der dem Phasenleiter R zugeordneten Eingangsschaltung 101 ist der an dem Messwiderstand 100 auftretende verbraucherstromproportionale Spannungsabfall über den Widerstand 102 zu dem verbraucherstromproportionalen Eingangssignal $i_R$ gewandelt. Die Dioden 103 und 104 dienen der Überspannungsbegrenzung. Als Bezugspotential für die Dioden 103 und 104 sowie für den Tastverhältnismodulator 105 dient der verbraucherfernere Anschluss des Messwiderstandes 100. Im Tastverhältnismodulator 105 wird das Eingangssignal $i_R$ zunächst in einem unter Einsatz eines Operationsverstärkers aufgebauten Vorverstärker 106 verstärkt und über den Widerstand 107 dem Eingang eines astabilen Multivibrators 108 zugeführt. Das Tastverhältnis des astabilen Multivibrators 108 schwenkt mit der Grösse des verbraucherstromproportionalen Eingangssignales $i_R$.

Der astabile Multivibrator 108 umfasst einen Operationsverstärker 109, dessen Ausgangssignal über den Widerstand 110 auf den invertierenden Eingang zurückgeführt ist. Ein Kondensator 111 verbindet den invertierenden Eingang des Operationsverstärkers 109 mit der als Bezugspotential die Phasenspannung R führenden Leitung 112. Der nichtinvertierende Eingang des Operationsverstärkers 109 liegt über dem Widerstand 113 am Bezugspotential. Das Ausgangssignal des Operationsverstärkers 109 ist über einen Widerstand 114 auf den nichtinvertierenden Eingang zurückgeführt. Zwei antiparallel angeordnete Referenzdioden 115 und 116 verbinden den Ausgang des Operationsverstärkers 109 mit der das Bezugspotential für den der Phase R zugeordneten Tastverhältnismodulator 105 führenden Leitung 112. Das Ausgangssignal des astabilen Multivibrators 108, das das Ausgangssignal des Tastverhältnismodulators 105 bildet, liegt über einen Widerstand 117 an einem als potentialtrennendes Übertragungsglied wirkenden Optokoppler 118 an. Eine der Leuchtdiode des Optokopplers 118 antiparallel geschaltete Diode 119 sorgt dafür, dass auch bei negierter Ausgangsspannung des Operationsverstärkers 109 ein Strom durch die Referenzdiode 116 fliessen kann. Da der Tastverhältnismodulator 105 potentialmässig auf Phasenspannung R liegt, wird durch den Einsatz des Optokopplers 118 die Übertragung des Tastverhältnisses auf Nullpotential ermöglicht. In der beschriebenen Schaltung wird zur Erregung der im Optokoppler 118 eingesetzten Leuchtdiode der gleiche Strom verwendet, der bereits für die Referenzdiode 115 gebraucht wird. Dies ist besonders vorteilhaft, weil dadurch die Versorgungsstromaufnahme des Tastverhältnismodulators 105 niedrig gehalten wird.

Das Ausgangssignal des Optokopplers 118 steht an einem Eingang eines Exklusiv-ODER-Gatters 120 an, das ausgangsseitig über den Widerstand 121 mit dem Gate-Anschluss des als Analogschalter 122 eingesetzten Feldeffekttransistors verbunden ist.

Der Tastverhältnismodulator 105 stellt in Verbindung mit dem Exklusiv-ODER-Gatter 120 sowie dem Analogschalter 122 den der Phase R zugeordneten Time-Division-Multiplizierer dar. In analoger Weise besteht der der Phase S zugeordnete Time-Division-Multiplizierer aus dem Tastverhältnismodulator 205, dem Exklusiv-ODER-Gatter 220 und dem Analogschalter 222, der der Phase T zugeordnete Time-Division-Multiplizierer aus dem Tastverhältnismodulator 305, dem Exklusiv-ODER-Gatter 320 und dem Analogschalter 322.

Durch den in der Eingangsschaltung 101 für die Phase R enthaltenen Analogschalter 122 wird das verbraucherspannungsproportionale Eingangssignal $u_R$ nach Wandlung in den dazu proportionalen Strom $i_{uR}$ über den Widerstand 123 in dem durch den Tastverhältnismodulator 105 vorgegebenen Tastverhältnis zerhackt. Die antiparallel angeordneten Dioden 124 und 125, die einseitig am Nullpotential liegen, dienen der Spannungsbegrenzung des Eingangssignales für den Analogschalter 122. Das auf der Leitung 126 geführte Ausgangssignal des Analogschalters 122 stellt als Ergebnis des Time-Division-Multiplikationsvorganges ein der Phase R entnommenes leistungsproportionales Signal dar.

Im Summenpunkt 27 sind alle drei derartige leistungsproportionale Signale für die Phasen R, S und T zusammengeführt.

Wie aus Fig. 2 ersichtlich ist, fehlt bei sämtlichen, den drei Phasen R, S und T zugeordneten Eingangsschaltungen 101, 201 und 301 gegenüber dem Stand der Technik jeweils der parallel zu der Serienschaltung aus Widerstand 123 und Analogschalter 122 bzw. Widerstand 223 und Analogschalter 222 bzw. Widerstand 323 und Analogschalter 322 angeordnete Überbrückungszweig, mit jeweils einem Umkehrverstärker sowie einem weiteren Widerstand. Wie bereits eingangs erläutert, ist dies ohne Beeinträchtigung der Funktion des erfindungsgemässen elektronischen Drehstrom-Elektrizitätszählers möglich, da für ein symmetrisches Spannungsdreieck sich die über die drei Überbrückungszweige geführten Ströme in jedem Augenblick zu Null ergänzen.

Die im Summenpunkt 27 zusammengeführten leistungsproportionalen Signale der den drei Phasen R, S und T zugeordneten Eingangsschaltungen 101, 201 und 301 sind einem gemeinsamen Strom-Frequenz-Wandler 28 zugeführt. Dieser Strom-Frequenz-Wandler 28 beinhaltet einen unter Einsatz eines Operationsverstärkers aufgebauten Integrator 29, dessen Ausgangssignal über einen aus den Widerständen 30 und 31 bestehenden Spannungsteiler dem Eingang eines ebenfalls unter Verwendung eines Operationsverstärkers aufgebauten Komparators zugeführt ist.

Den Eingang des Komparators 32 bildet der invertierende Eingang des Operationsverstärkers 33, dessen Ausgangssignal über den Widerstand 34 und die dazu in Serie angeordnete Antiparallelschaltung zweier Referenzdioden 35 und 36 auf das Nullpotential gelegt ist. Der nichtinvertierende Eingang des Operationsverstärkers 33 ist einerseits über den Widerstand 37 ebenfalls auf Nullpotential gelegt, andererseits über den einstellbaren Widerstand 38 mit dem dem Operationsverstärker 33 abgewandten Ende des Widerstandes 34 verbunden. Über den einstellbaren Widerstand 38 sowie die beiden Referenzdioden 35 und 36 sind die beiden Grenzwerte des Komparators 32 vorgebbar.

Das Ausgangssignal des Komparators 32 ist über eine Diode 39 dem jeweils anderen Eingang der in den Eingangsschaltungen 101, 201 und 301 enthaltenen Exklusiv-ODER-Gatter 120, 220 und 320 zugeführt. Die Diode 39 dient der Unterdrückung des negativen Signalanteils des Operationsverstärkers 33. Bei dem einen Zustand des Ausgangssignals des Komparators 32 erfolgt die Taktung der Analogschalter 122, 222 und 322 durch die Tastverhältnismodulatoren 105, 205 und 305 derart, dass im Summenpunkt 27 ein der Summe der den drei Phasen R, S und T entnommenen Leistungen proportionaler Summenstrom entsteht, der zur langsamen Aufladung des Integrationskondensators 40 des Integrators 29 führt, bis das Ausgangssignal des Integrators 29 den einen Grenzwert des Komparators 32 erreicht. In diesem Augenblick ändert der Komparator 32 sein Ausgangssignal und damit seinen Zustand. Damit werden über die Exklusiv-ODER-Gatter 120, 220 und 320 nur noch die negierten Ausgangssignale der Tastverhältnismodulatoren 105, 205 und 305 zur Ansteuerung des Analogschalters 122 verwendet, so dass nunmehr im Summenpunkt 27 wiederum ein den drei Phasen entnommener leistungsproportionaler Strom, aber diesmal umgekehrter Polarität entsteht, wodurch der Integrationskondensator 40 des Integrators 29 langsam entladen wird, bis der zweite Grenzwert des Komparators 32 erreicht ist, worauf wiederum ein Signalwechsel am Ausgang des Komparators 32 auftritt. Die Frequenz der Signalwechsel am Ausgang des Komparators 32 ist proportional zu der den drei Phasen R, S und T entnommenen Gesamtleistung.

Die Summe dieser Signalwechsel über eine bestimmte Zeitspanne ist ein Mass für die dem speisenden Drehstromnetz während dieser Zeitspanne entnommene Energie. Zur Summation dieser Signalwechsel ist das Ausgangssignal des Komparators 32 einem Frequenzteiler 41 zugeführt, der über den Widersand 42 einen Schalttransistor 43 ansteuert. Der Schalttransistor 43 schaltet ein Impulsrelais 44, das beispielsweise ein Rollenzählwerk antreibt, wobei der Schaltstrom für das Impulsrelais 44 überwiegend durch einen parallelgeschalteten Kondensator 45 aufgebracht wird, der zwischen dem Nullpotential und der positiven Versorgungsspannung $+U_o$ liegt. Der Frequenzteiler 41 dient dazu, die für den Antrieb eines elektromechanischen Zählwerkes zu hohe Ausgangsfrequenz des Komparators 32 auf einen für ein derartiges Zählwerk geeigneten Wert zu untersetzen. Parallel zum Frequenzteiler 41 ist über einen Widerstand 46 eine Leuchtdiode 47 gespeist, die im Takt der Signalwechsel des Komparators sichtbares Licht emittiert und damit in ihrer Wirkung der roten Läufermarke eines Ferrariszählers entspricht. Die aus den Bauelementen 41 bis 47 bestehende Funktionseinheit stellt eine kumulierende Zähleinrichtung 48 zur Erfassung des Energieverbrauches dar.

Im vorliegenden Ausführungsbeispiel wurden die verbraucherstrom- und verbraucherspannungsproportionalen Eingangssignale für die Eingangsschaltungen 101, 201 und 301 ohne den Einsatz von Strom- bzw. Spannungswandlern gewonnen, indem in jedem Phasenleiter R, S und T ein Messwiderstand 100, 200 und 300 zur Erfassung des Verbraucherstromes eingefügt ist und zur Bildung eines der Verbraucherspannung proportionalen Signals eine Widerstandsankopplung an die Phasenleiter vorgesehen ist. Die erfindungsgemässe Lösung ist in gleicher Weise anwendbar, wenn die verbraucherstrom- bzw. verbraucherspannungsproportionalen Signale über Strom- und Spannungswandler gewonnen sind. Bei der im Ausführungsbeispiel vorgenommenen Direktankopplung der Eingangsschaltungen 101, 201 und 301 an die Phasenleiter R, S und T des Drehstromnetzes entfallen sämtliche Strom- und Spannungswandler. Allerdings liegen hierbei die Tastverhältnismodulatoren 105, 205 und 305 potentialmässig auf den Phasenspannungen R, S, und T. Der Rest der Schaltungsanordnung, also beispielsweise der Strom-Frequenz-Wandler 28 und die Zähleinrichtung 48 liegen auf Nullpotential. Daher ist es erforderlich, die genannten Tastverhältnismodulatoren 105, 205 und 305 sowie den verbleibenden Rest der Schaltungsanordnung durch vier potentialgetrennte Gleichspannungsversorgungsquellen zu speisen.

Im vorliegendne Ausführungsbeispiel ist das verbraucherstromproportionale Eingangssignal jeweils den Tastverhältnismodulatoren 105, 205 und 305 zugeführt, wohingegen das verbraucherspannungsproportionale Eingangssignal jeweils über den den Analogschalter 122, 222 und 322 enthaltenden Zweig des Time-Division-Multiplizierers geführt ist. Eine Vertauschung der Eingangssignale ist ebenfalls möglich, wobei dann jeweils das verbraucherspannungsproportionale Eingangssignal dem Tastverhältnismodulator und das verbraucherstromproportionale Eingangssignal dem den Analogschalter enthaltenden Zweig des Time-Division-Multiplizierers zugeführt ist.

Fällt bei dem vorliegenden elektronischen Drehstromzähler eine Phasenspannung vor dem Zähler aus, so entsteht lediglich ein Zusatzfehler, der etwa bei 4% liegt und in etwa dem eines Ferrariszählers entspricht.

## Patentansprüche

1. Elektronischer Drehstrom-Elektrizitätszähler für das Kondensatorumladungsverfahren, bei dem jeder Phase des Drehstromnetzes ein einen Tastverhältnismodulator und einen Analogschalter aufweisender Time-Division-Multiplizierer zugeordnet ist, zur Verarbeitung der der betreffenden Phase zugeordneten verbraucherstrom- und verbraucherspannungsproportionalen Eingangssignale, von denen das eine Eingangssignal den Tastverhältnismodulator aussteuert und das andere Eingangssignal über den vom Tastverhältnismodulator getakteten Analogschalter zum Ausgang des Time-Division-Multiplizierers geführt ist, und bei dem die Ausgangsströme der drei Time-Division-Multiplizierer einem gemeinsamen Strom-Frequenz-Wandler zugeführt sind, dessen Ausgangssignal eine kumulierende Zähleinrichtung zur Erfassung des Energieverbrauches speist, dadurch gekennzeichnet, dass dem Strom-Frequenz-Wandler (28) ausschliesslich die drei Ausgangsströme ($i_{uR}$; $i_{uS}$; $i_{uT}$) der von den jeweiligen Tastverhältnismodulatoren (105; 205; 305) getakteten Analogschalter (122; 222; 322) zugeführt sind.

2. Drehstrom-Elektrizitätszähler nach Patentanspruch 1, dadurch gekennzeichnet, dass die verbraucherstrom- und verbraucherspannungsproportionalen Eingangssignale direkt von den Phasenleitern (R; S; T) abgegriffen sind, indem als verbraucherstromproportionales Eingangssignal der Spannungsabfall eines in jeden Phasenleiter (R; S; T) eingefügten Messwiderstandes (100; 200; 300) und als verbraucherspannungsproportionales Eingangssignal der Strom in einem an den jeweiligen Phasenleiter (R; S; T) angeschlossenen Widerstand (123; 223; 323) dient.

3. Drehstrom-Elektrizitätszähler nach Patentanspruch 1 oder 2, dadurch gekennzeichnet, dass zur Taktung jedes Analogschalters (122; 222; 322) jeweils ein Exklusiv-ODER-Gatter (120; 220; 320) vorgesehen ist, dessen einer Eingang mit dem Ausgangssignal des der jeweiligen Phase (R; S; T) zugeordneten Tastverhältnismodulators (105; 205; 305) und dessen anderer Eingang mit dem Ausgangssignal des Strom-Frequenz-Wandlers (28) beaufschlagt ist.

4. Drehstrom-Elektrizitätszähler nach einem der Patentansprüche 1 bis 3, dadurch gekennzeichnet, dass jeder Tastverhältnismodulator (105; 205; 305) das verbraucherstromproportionale Eingangssignal ($i_R$; $i_S$; $i_T$) verarbeitet.

5. Drehstrom-Elektrizitätszähler nach den Patentansprüchen 2 und 4, dadurch gekennzeichnet, dass als Bezugspotential für jeden Tastverhältnismodulator (105; 205; 305) das Potential am verbraucherferneren Anschluss des zugehörigen Messwiderstandes (100; 200; 300) dient.

6. Drehstrom-Elektrizitätszähler nach den Patentansprüchen 2 und 5, dadurch gekennzeichnet, dass das Ausgangssignal jedes Tastverhältnismodulators (105; 205; 305) über ein potentialtrennendes Übertragungsglied (118; 218; 318) dem anderen Eingang des Exklusiv-ODER-Gatters (120; 220; 320) zugeführt ist.

7. Drehstrom-Elektrizitätszähler nach einem der Patentansprüche 1 bis 6, dadurch gekennzeichnet, dass der Strom-Frequenz-Wandler (28) einen Integrator (29) sowie einen nachgeschalteten Komparator (32) mit zwei Grenzwerten umfasst.

8. Drehstrom-Elektrizitätszähler nach einem der Patentansprüche 1 bis 7, dadurch gekennzeichnet, dass die Zähleinrichtung (48) einen mit dem Ausgangssignal des Strom-Frequenz-Wandlers (28) beaufschlagten Frequenzteiler (41) enthält, der einen Schalttransistor (43) zur Betätigung eines elektromechanischen Zählwerkes (44) steuert.

## Revendications

1. Compteur d'électricité triphasé électronique pour le procédé d'échange de charge d'un condensateur, dans lequel est associé à chaque phase du réseau triphasé un multiplicateur par partage du temps (TDM), comportant un modulateur du taux d'impulsions et un commutateur analogique et servant au traitement des signaux d'entrée proportionnels au courant de l'abonné et à la tension de l'abonné, et dont l'un commande des signaux d'entrée du modulateur du taux d'impulsions et l'autre signal d'entrée est appliqué, par l'intermédiaire du commutateur analogique cadencé par le modulateur du taux d'impulsions, à la sortie du multiplicateur par partage du temps, et dans lequel les courants de sortie des trois multiplicateurs par partage du temps sont amenés à un convertisseur courant-fréquence commun dont le signal de sortie alimente un dispositif de comptage cumulatif pour saisir la consommation d'énergie, caractérisé par le fait qu'au convertisseur courant-fréquence (28) sont amenés exclusivement les trois courants de sortie ($I_{uR}$; $i_{uS}$; $i_{uT}$) des interrupteurs analogiques (122; 222; 322) cadencés par les modulateurs respectifs (105; 205; 305) des taux d'impulsions.

2. Compteur d'électricité triphasé selon la revendication 1, caractérisé par le fait que les signaux d'entrée proportionnels au courant d'abonné et à la tension d'abonné sont prélevés directement à partir des conducteurs de phase (R; S; T) en se servant pour le signal d'entrée proportionnel au courant de l'abonné de la chute de tension aux bornes d'une résistance de mesure (100; 200; 300) insérée dans chacun des conducteurs de phase (R; S; T) et pour le signal d'entrée proportionnel à la tension de l'abonné d'une résistance (123; 223; 323) branchée sur chacun des conducteurs de phase (R; S; T).

3. Compteur d'électricité triphasé selon la revendication 1 ou 2, caractérisé par le fait que pour cadencer chacun des commutateurs analogiques (122; 222; 322) il est prévu une porte OU-Exclusif respective (120; 220; 320) dont une entrée reçoit le signal de sortie du modulateur de taux d'impulsions (105, 205; 305) associé à la phase respective (R; S; T) et dont l'autre entrée reçoit le signal de sortie du convertisseur courant-fréquence (28).

4. Compteur d'électricité triphasé selon l'une des revendications 1 à 3, caractérisé par le fait que chaque modulateur du taux d'impulsions (105; 205; 305) traite le signal d'entrée ($i_R$; $i_S$; $i_T$) proportionnel au courant consommé par l'abonné.

5. Compteur d'électricité triphasé selon les revendications 2 et 4, caractérisé par le fait que pour chacun des modulateurs du taux d'impulsions (105; 205; 305) le potentiel au niveau du branchement de la résistance de mesure associée (100; 200; 300) éloigné sert de potentiel de référence.

6. Compteur d'électricité triphasé selon les revendications 2 et 5, caractérisé par le fait que le signal de sortie de chaque modulateur du taux d'impulsions (105; 205; 305) est appliqué, par l'intermédiaire d'un élément de transfert à découplage de potentiel (118; 218; 318), à ladite autre entrée de la porte OU-Exclusif (120; 220; 320).

7. Compteur d'électricité triphasé selon l'une des revendications 1 à 6, caractérisé par le fait que le convertisseur courant-fréquence (28) comporte un intégrateur (29) ainsi qu'un comparateur aval (32) à deux valeurs limites.

8. Compteur d'électricité triphasé selon l'une des revendications 1 à 7, carctérisé par le fait que l'installation de comptage (48) comporte un diviseur de fréquence (40) auquel est appliqué le signal de sortie du convertisseur courant-fréquence (28) et qui commande un transistor de commutation (43) pour commander le dispositif compteur électromécanique.

**Claims**

1. Electronic three-phase electricity meter for capacitive re-charging operation, wherein each phase of the three-phase mains is assigned a time-division-multiplier which comprises a pulse-duty factor modulator and an analogue switch, for the processing of the input signals which are assigned to the phase in question and which are proportional to the consumer current and consumer voltage and of which one input signal controls the pulse-duty factor modulator and the other input signal leads via the analogue switch, which is pulsed by the pulse-duty factor modulator, to the output of the time-division-multiplier, and wherein the output currents of the three time-divison-multipliers are assigned to a common current-frequency converter whose output signal feeds an accumulating metering device for the recordal of energy consumption, characterised in that the current-frequency converter (28) is supplied only with the three output currents ($i_{uR}$; $i_{uS}$; $i_{uT}$) of the analogue switches (122, 222, 322) pulsed by the associated pulse-duty factor modulators (105, 205, 305).

2. Three-phase electricity meter as claimed in claim 1, characterised in that the input signals which are proportional to consumer current and consumer voltage are tapped directly from the phase control devices (R; S; T) in that the voltage drop across a measuring resistor (100; 200; 300) interposed into each phase control device (R; S; T) serves as input signal which is proportional to the consumer current, and the current in a resistor (123; 223; 323) connected to the phase control device (R; S; T) in question serves as input signal which is proportional to the consumer voltage.

3. Three-phase electricity meter as claimed in patent claim 1 or 2, characterised in that each analogue switch (122; 222; 322) is pulsed by means of an EXCLUSIVE-OR-GATE (120; 220; 320) whose first input is supplied with the output signal from the pulse-duty factor modulator (105; 205; 305) assigned to the phase (R; S; T) in question and whose other input is supplied with the output signal from the current-frequency converter (28).

4. Three-phase electricity meter as claimed in one of the patent claims 1 to 3, characterised in that each pulse-duty factor modulator (105; 205; 305) processes the input signal ($i_R$; $i_S$; $i_T$) which is proportional to the consumer current.

5. Three-phase electricity meter as claimed in patent claims 2 and 4 characterised in that the potential carried by that terminal of the associated measuring resistor (100; 200; 300) which is more remote from the consumer serves as reference potential for each pulse-duty factor modulator (105; 205; 305).

6. Three-phase electricity meter as claimed in the patent claims 2 and 5, characterised in that the output signal of each pulse-duty factor modulator (105; 205; 305) is fed via a potential isolating transmission element (118; 218; 318) to the other input of the EXCLUSIVE-OR-GATE (120; 220; 320).

7. Three-phase electricity meter as claimed in one of the patent claims 1 to 6, characterised in that the current-frequency converter (28) comprises an integrator (29) and a following comparator (32) which possesses two limit values.

8. Three-phase electricity meter as claimed in one of the patent claims 1 to 7, characterised in that the metering device (48) contains a frequency divider (41) which is supplied with the output signal of the current-frequency converter (28) and controls a switching transistor (43) which serves to actuate an electro-mechanical metering unit (44).

FIG 1

# FIG 2

| FIG 2A | FIG 2B |
|--------|--------|

## FIG 2A

# FIG 2B